# EUROPÄISCHE PATENTSCHRIFT

(11) **EP 0 829 189 B1**
(45) Veröffentlichungstag und Bekanntmachung des Hinweises auf die Patenterteilung: **27.01.1999**
(21) Anmeldenummer: 95928429.0
(22) Anmeldetag: 16.08.1995
(51) Int. Cl.: H05K 7/14

(54) **UNIVERSELLE, MODULARE FÜHRUNGSSCHIENE FÜR LEITERPLATTEN**
UNIVERSAL, MODULAR GUIDING RAIL FOR PRINTED CIRCUIT BOARDS
RAILS MODULAIRES UNIVERSELS DE GUIDAGE DE PLAQUETTES DE CIRCUITS IMPRIMES

(30) Priorität: 29.05.1995 DE 29508853 U
(43) Veröffentlichungstag der Anmeldung: 18.03.1998
(73) Patentinhaber: SIEMENS AKTIENGESELLSCHAFT, 80333 München (DE)
(72) Erfinder: BILLENSTEIN, Ernst, D-91593 Burgbernheim (DE); KÖRBER, Werner, D-91282 Betzenstein (DE); KURRER, Siegfried, D-90449 Nürnberg (DE); SCHAFFER, Kurt-Michael, D-90542 Eckental (DE)
(86) Internationale Anmeldenummer: DE9501075
(87) Internationale Veröffentlichungsnummer: WO9639013

(56) Entgegenhaltungen:
- DE-A- 3 624 839
- DE-A- 3 624 883
- DE-C- 4 210 466
- GB-A- 1 053 352
- US-A- 5 001 606
- RESEARCH DISCLOSURE, Nr. 346, 1.Februar 1993 Seite 91 XP 000358768 'POSITIVE KEYING GUIDE/RAIL ASSEMBLY'

## Beschreibung

Aus der DE 36 24 839 C2 ist eine Führungsschiene für Leiterplatten bekannt, bei der eine Seitenwand der Führungsnut mittels Schlitzen abschnittsweise vom Nutgrund getrennt ist. Diese freien Teile der Seitenwand der Führungsnut sind jeweils derart als glockenkurvenförmige Blattfedern gestaltet, daß die Breite der Führungsnut jeweils verjüngt ist. Diese glockenkurvenförmigen Blattfedern verengen die Führungsnut derart, daß sowohl Leiterplatten mit der geringsten Dicke beidseitig noch geführt sind, als auch Leiterplatten mit der größten Dicke noch eingeschoben werden können.

Eine weitere bei Führungsschienen in der Praxis auftretende Randbedingung besteht darin, daß diese entsprechend der jeweiligen Tiefe einer Leiterplatte gegebenenfalls unterschiedliche Längen aufweisen müssen. Bislang war es üblich und notwendig, für jede Leiterplattentiefe einen eigens angepaßten, separaten Führungsschienentyp vorzusehen. Hierdurch wurden der Bauteile- und Fertigungsaufwand und die Kosten erhöht.

Der Erfindung liegt nun die Aufgabe zugrunde, eine universelle Führungsschiene für Leiterplatten anzugeben, welche ohne größeren Aufwand baukastenartig an Leiterplatten anpaßbar ist, welche sowohl eine unterschiedliche Dicke als auch eine unterschiedliche Kantenlänge bzw. Tiefe aufweisen können.

Die Aufgabe wird gelöst mit der im Anspruch 1 angegebenen Führungsschiene. Weitere vorteilhafte Ausgestaltungen derselben sind in den Unteransprüchen angegeben.

Ein Vorteil der erfindungsgemäßen, modularen Führungsschiene wird darin gesehen, daß auf Grund der kopfartigen Aufrast- bzw. Aufsteckbarkeit der Nutsegmentteile auf die Tragschiene zum einen die Längenanpassung der Führungsschiene an die aktuelle Kantenlänge einer Steckbaugruppe erleichtert wird. Hierzu wird die Tragschiene in der Länge an die jeweilige Steckbaugruppe entsprechend angepaßt. Anschließend werden bausteinartig so viele Nutsegmentteile auf die Tragschiene aufgesetzt, daß der Bereich auf der Oberseite der Tragschiene zwischen den beiden Endstücken möglichst vollständig mit Nutsegmentteilen abgedeckt ist und sich somit eine möglichst durchgehende, bündige Führungsnut über die Gesamtlänge der Kante der Steckbaugruppe ergibt.

Ein weiterer Vorteil wird ferner darin gesehen, daß auch die Anpassung der Führungsschiene an Steckbaugruppen mit unterschiedlicher Dicke durch die erfindungsgemäße Gestaltung erheblich begünstigt wird. Bedingt durch das kopfartige Aufsetzen der Nutsegmentteile auf die Tragschiene wirkt die Tragschiene vorrangig funktionell als reine Unterstützung und engt die Führungsnutsegmente auf der Oberseite der Nutsegmentteile bezüglich von deren Querschnittsausdehnung in keiner Weise ein. So ist es zum einen möglich, unterschiedliche, bezüglich der Breite der Führungsnutsegmente für verschieden dicke Leiterplatten vorgesehene Nutsegmentteile aufzusetzen. Andererseits sind aber auch die beiden, ein Führungsnutsegment auf der Oberseite eines Nutsegmentteiles begrenzende Seitenwände vollkommen frei und können bei der Einführung einer dicken Leiterplatte in die Führungsnut entsprechend ihren Materialeigenschaften seitlich ausweichen.

Besonders vorteihaft ist es, wenn entsprechend der aus der DE 36 24 839 C2 bekannten Gestaltung bei einem Nutsegmentteil eine Seitenwand des dortigen Führungsnutsegments mittels eines Schlitzes abschnittsweise vom Nutgrund getrennt und dieser freie Teil der Seitenwand jeweils derart als glockenkurvenförmige Blattfeder gestaltet ist, so daß die Breite des Führungsnutsements auf der Oberseite des jeweiligen Nutsegmentteils verjüngt ist.

Die Erfindung wird mit den in den nachfolgend kurz angeführten Figuren dargestellten Beispielen weiter erläutert. Dabei zeigt
- Fig.1.: eine Querschnittsdarstellung einer erfindungsgemäßen Führungsschiene, deren Tragschiene beispielhaft einen rechteckigen Querschnitt aufweist und auf die ein Nutsegmentteil kopfartig aufgesetzt ist,
- Fig.2.: eine perspektivische Draufsicht auf eine bevorzugte Ausführungsform eines Endstücks und einer Tragschiene der erfindungsgemäßen Führungsschiene mit einem beispielhaft aufgesetzten Nutsegmentteil,
- Fig.3.: eine Querschnittsdarstellung der bevorzugten Ausführungsform der Führungsschiene von Figur 2 im Bereich der Tragschiene,
- Fig.4.: eine Draufsicht auf den Kupplungsbereich des Endstückes der Führungsschiene von Figur 2, und
- Fig.5.: eine Querschnittsdarstellung einer weiteren Ausführungsform der Führungsschiene, wobei insbesondere die Unterseite der Tragschiene eine bevorzugte strömungsgünstige, bootsförmige Außenkontur aufweist.

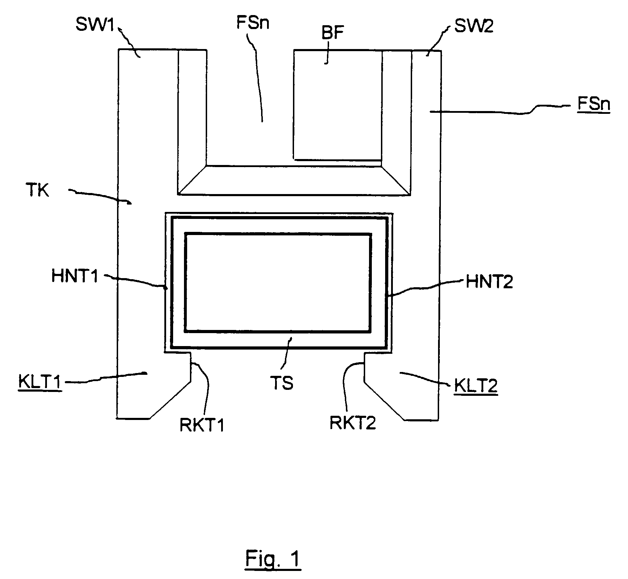

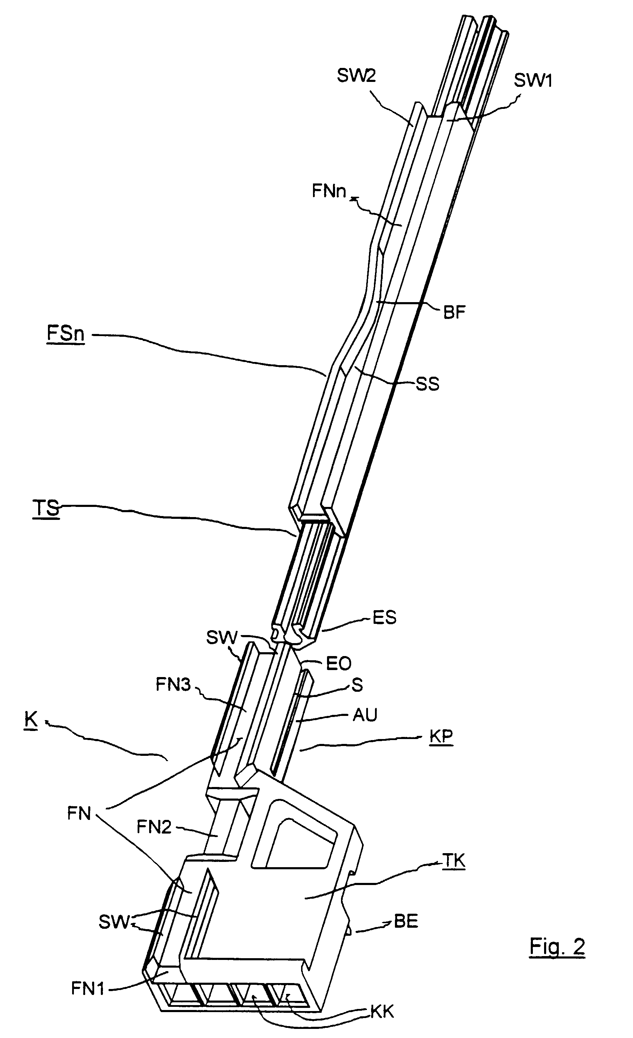

Figur 1 zeigt eine Querschnittsdarstellung einer ersten Ausführungsform der erfindungsgemäßen Führungsschiene, bei der die Tragschiene TS beispielhaft einen rechteckigen Querschnitt aufweist. Auf die Tragschiene ist ein Nutsegmentteil FSn erfindungsgemäß kopfartig aufgesetzt bzw. darauf verrastet oder aufgesteckt. Hierzu weist das Nutsegmentteil FSn Rastelemente auf, welche von dessen Unterseite abgehen. Im Beispiel der Figur 1 sind diese Rastelemente ausgeführt in Form von zwei Kantleisten KLT1 und KLT2, welche von den Flanken des Tragkörpers TK des Nutsegmentteils nach unten abgehen und am Ende jeweils eine vorspringende Rastkante RKT1,RKT2 aufweist. Diese sind im Beispiel der Figur 1 nach innen vorspringend und bilden somit jeweils einen dahinter liegenden Nutbereich NHT1,NHT2, in welche die rechteckförmige Tragschiene TS nach dem Einrasten zu liegen kommt. Im dargestellten Beispiel wird somit die Tragschiene TS von den Rastelementen KLT1,KLT2 umfaßt. Bei anderen Ausführungen, von denen eine nachfolgend an Hand der Figuren 2 bis 4 noch näher erläutert werden wird, können an den Seiten der Tragschiene auch Nuten vorgesehen sein, in welche die Rastelemente des Nutsegmentteils eingreifen. Andererseits können die Rastelemente auch Bestandteil der Tragschiene sein, welche z.B. in an der Unterseite des Tragkörpers TK des Nutsegmentteils befindliche Stege, Nuten und dergleichen eingreifen.

Entscheidend ist, daß die Verbindung zwischen Nutsegmentteil und Tragschiene unterhalb des Tragkörpers TK des Nutsegmentteils FSn erfolgt, so daß die kopfartige Oberseite des Nutsegmentteils FSn, auf der das zur Aufnahme der Kante einer Steckbaugruppe dienende Führungsnutsegment FSn, begrenzt durch zwei Seitenwände SW1,SW2, vollkommen unbehindert ausgebildet werden kann. Das Führungsnutsegment und die dieses bildenden Seitenwände sind somit auf Grund der erfindungsgemäßen Gestaltung bezüglich einer seitlichen Erweiterung bzw. Ausdehnung insbesondere zum Zwecke der Aufnahme von Leiterplatten mit größerer Dicke in keiner Weise eingeschränkt. So ist im Beispiel der Figur 1 die rechte Seitenwand SW2 bereichsweise vom Nutgrund getrennt und blattfederartig, das Führungsnutsegment FSn abschnittsweise verengend ausgebildet. Insbesondere bei Einschieben einer besonders dicken Leiterplatte wird dieser blattfederartige Bereich so verformt, daß er über die in Figur 1 dargestellte rechte Begrenzung der Seitenwand SW2 hinausgedrückt wird. Derartige Dehnungen in Querrichtung sind auf Grund der erfindungsgemäßen Verbindung von Tragschiene und Führungsnutsegment durch auf der Unterseite des Führungsnutsegments befindliche Rastelemente ohne weiteres möglich.

Eine weitere Ausführungsform der Erfindung wird an Hand der perspektivischen Draufsicht von Figur 2 erläutert. Dort ist eine bevorzugte Ausführung eines Endstückes K der erfindungsgemäßen Führungsschiene dargestellt. Es handelt sich dabei bevorzugt um das sogenannte vordere Endstück einer Führungsschiene, welche im dargestellten Fall zusätzlich Kodierkammern KK aufweist. Diese sind der einzusteckenden Leiterplatte zugewandt und können mit Kodierstiften gefüllt werden. Hiermit kann gewährleistet werden, daß tatsächlich nur die für einen Steckplatz vorgesehene Leiterplatte in die entsprechende Führungsschiene vollständig eingeschoben werden kann. Aus Gründen der Übersichtlichkeit ist das am anderen Ende der Tragschiene TS befindliche Endstück der Führungsschiene nicht dargestellt. Es kann vorteilhaft die gleiche Gestaltung wie das gezeigte vordere Endstück K aufweisen, bzw. es können zumindest die Kodierkammern entfallen, da diese an der Rückseite eines Baugruppenträgers nicht benötigt werden.

Das in Figur 2 dargestellte vordere Endstück K verfügt über einen Kupplungsbereich KP zur Verbindung mit einem gegenüberliegenden Einsteckbereich ES einer Tragschiene TS. Auf der Oberseite des Tragkörpers TK des Endstücks K ist beispielhaft durch zwei seitlich begrenzende Seitenwände SW ein Führungsnutsegment FN zur Aufnahme der Kante einer Leiterplatte ausgebildet. Auf der Unterseite des Tragkörpers TK sind weitere Befestigungselemente BE vorhanden, insbesondere Rasthaken und/oder Führungsbolzen bzw. Einstecknoppen, welche zur Halterung des Endstücks K und damit der gesamten modularen Führungsschiene in entsprechende Öffnungen bzw. Leisten einer in Figur 1 nicht dargestellten Querschiene eines Baugruppenträgers dienen.

Bei dem in Figur 2 dargestellten Beispiel ist die Führungsnut auf der Oberseite des Endstücks K beispielsweise dreigeteilt. Ein erster Bereich FN1 an der Stirnseite weist Einführschrägen zur leichteren Einführung der Kante einer Steckbaugruppe auf. Dahinter schließt sich ein zweiter Bereich FN2 der Führungsnut annähernd in der Mitte der Oberseite des Tragkörpers an. Bei diesem sind anstelle der Seitenwände beidseitig des Nutgrundes Durchbruchöffnungen zur Aufnahme einer Kontaktfeder vorgesehen. Eine derartige Kontaktfeder ist z.B. in der DE 36 24 883 C2 beschrieben und dient dazu, daß Massepotential der Leiterplatte und des Baugruppenträgers miteinander zu verbinden. Schließlich ist ein dritter, oberhalb des Kupplungsbereichs KP liegender Bereich FN3 der Führungsnut vorhanden. Dieser bildet den Übergang zu den Führungsnutsegmenten FSn auf den Oberseiten der Nutsegmentteile FSn, welche auf die Tragschiene TS aufgerastet sind.

Im Beispiel der Figur 2 ist auf der Tragschiene TS beispielhaft nur ein einziges derartiges Nutsegmentteil verrastet. Im Normalfall wird die gesamte Oberseite der auf die Länge der jeweils einzuschiebenden Steckbaugruppen angepaßte Tragschiene mit Nutsegmentteilen vollständig belegt. Dabei sind die beiden Endstücke, die Tragschiene und die anwendungsabhängige Anzahl an Nutsegmentteilen so aufeinander abgestimmt, daß die Führungsnutsegmente auf den einzelnen Teilen bündig, d.h. kantenfrei, zueinander zu liegen kommen und sich somit eine stoßfreie, durchgehende Führungsnut vom Beginn des vorderen Endstückes über alle Nutsegmentteile bis zum hinteren Endstück ergibt.

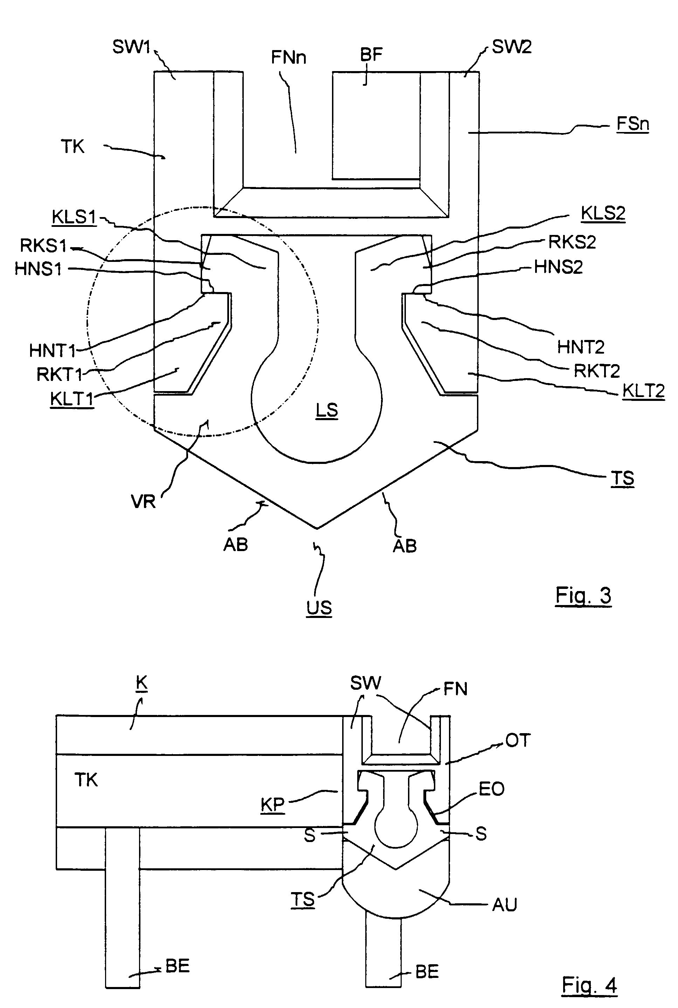

Die bevorzugte Ausführung der Tragschiene TS und der Nutsegmentteile FSn der Führungsschiene von Figur 2 wird nachfolgend anhand einer Querschnittsdarstellung im Bereich der Tragschiene gemäß Figur 3 näher beschrieben. Dabei weisen sowohl die Nutsegmentteile FNn als auch die Tragschiene TS Rastelemente auf, welche annähernd invers zueinander geformt sind und somit optimal formschlüssig ineinander eingreifen.

Hierzu sind in Figur 2 beispielhaft die Rastelemente der Tragschiene TS in Form von zwei von der Oberseite der Tragschiene TS abweisenden Kantleisten KLS1,KLS2 mit vorspringenden, bevorzugt nach außen abgewandten Rastkanten RKS1,RKS2 ausgeführt sind. Hierdurch ist es zum einen möglich, daß die Kantleisten KLT1,KLT2 der Nutsegmentteile FSn in die durch die Kantleisten KLS1,KLS2 der Tragschiene TS gebildeten Nutbereiche HNS1,HNS2 eingreifen, und im Gegenzug die Kantleisten KLS1,KLS2 der Tragschiene TS in die von den Kantleisten KLT1,KLT2 der Nutsegmentteile FSn gebildeten Nutbereiche HNT1,HNT2 eingreifen. Es ergeben sich somit optimale Verzahnungsbereiche VR zwischen den Kantleisten KLS1,KLS2 der Tragschiene TS und den Kantleisten KLT1,KLT2 der Nutsegmentteile FSn.

Vorteilhaft weist die Führungsschiene TS ein näherungsweise u-förmiges Querschnittsprofil auf. Im Beispiel der Figur 2 wird dies durch einen Längsschlitz LS gewährleistet, welcher sich bevorzugt im unteren Bereich im Zentrum der Tragschiene tropfenförmig erweitert. Hierdurch wird auch eine die Aufrastbarkeit der Nutsegmentteile begünstigende Elastizität der Kantleisten KLS1,KLS2 der Tragschiene TS erreicht. Gemäß einer weiteren, in Figur 3 bereits dargestellten Ausführungsform weist die den kopfartig aufgesteckten Nutsegmentteilen FSn abgewandte Unterseite US der Tragschiene TS zwei dachförmige Schrägflächen AB auf. Hierdurch wird ein zur Kühlung von Bauelementen auf den Oberseiten der Steckbaugruppen dienender Kühlluftstrom, welcher von der Unterseite US der Führungsschiene herangeführt wird, optimal weitergeleitet. Dies ist insbesondere dann notwendig, wenn bei einer dichten Bestückung eines Baugruppenträgers mit Steckbaugruppen viele Führungsschienen eng parallel nebeneinander angeordnet sind.

Figur 4 zeigt schließlich eine Draufsicht auf den Kupplungsbereich KP des Endstückes K der Führungsschiene von Figur 2. Auf der linken Seite sind die Rückansicht des Tragkörpers TK und die Rastelemente BE des Endstückes K dargestellt. Vorteilhaft weist der Kupplungsbereich KP des Endstücks K eine dem Querschnittsprofil der Tragschiene TS entsprechende Einstecköffnung EO für das den Einsteckbereich ES bildende Ende der Tragschiene TS auf. Hierdurch ist ein besonders sicherer Halt der eingesteckten Tragschiene TS im Endstück K gewährleistet. Vorteilhaft weist der oberhalb der Einstecköffnung EO befindliche Teil OT des Kupplungsbereichs KP des Endstücks K eine mit den Nutsegmentteilen FSn möglichst übereinstimmende Querschnittsform auf. Dies ist im Beispiel der Figur 4 gegeben. So verfügt auch das Endstück über Kantleisten, welche in die komplementären Kantleisten der Tragschiene optimal formschlüssig eingreifen. Dies hat den weiteren Vorteil, daß der Übergang zwischen einem Endstück und einem Nutsegmentteil unter Vermeidung von jeglichen Überständen vollkommen kantfrei erfolgt. Im Beispiel der Figur 4 ist die Auflagekufe AU für die dachförmigen Schrägflächen AB auf der Unterseite der Tragschiene TS besonders stabil ausgeführt. Hierdurch können unerwünschte Verwindungen zwischen den beiden Endstücken und der Tragschiene vermieden werden.

Vorteilhaft sind im Inneren des Kupplungsbereiches KP der Endstücke K zusätzliche, in Figur 4 nicht sichtbare Rastelemente vorhanden, z.B. eingelassen in das Innere der Auflagekufe AU. Diese rasten entweder formschlüssig in entsprechende Ausschnitte in der Tragschiene TS ein oder liegen unter Aufbringung einer ensprechenden Druckbelastung flächig auf den Außenseiten der Tragschiene auf. Hierdurch kann die Halterung bzw. Klemmung zwischen dem Einsteckbereich ES einer Tragschiene TS und dem Kupplungsbereich KP eines Endstücks K erheblich verbessert werden.

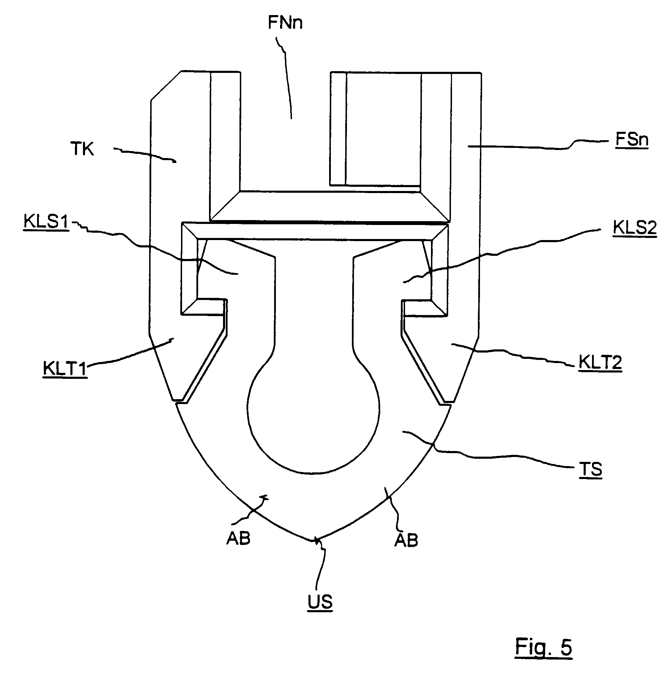

Schließlich ist in Figur 5 eine weitere Querschnittsdarstellung durch.eine Führungsschiene TS mit aufgesetztem Nutsegmentteil FSn gezeigt. Dabei sind insbesondere die Außenseiten AB auf der Unterseite US der Tragschiene TS besonders strömungsgünstig für einen von unten zugeleiteten Kühlluftstrom gestaltet. Im dagestellten Beispiel hat die Unterseite annähernd die Form eines Bootsrumpfes. gemäß einer nicht dargestellten Ausführung kann er auch V-förmig sein. Diese Rumpfform verlängert sich nach oben auf beiden Seiten bis hin zu den beiden nach unten weisenden Kantleisten KLT1,KLT2, so daß insbesondere die Außenseiten der nach innen vorspringenden Rastkanten RKT1,RKT2 ebenfalls nach unten abgeschrägt sind.

## Patentansprüche

1. Führungsschiene zur Halterung von Steckbaugruppen in einem Baugruppenträger, mit
a) einer an die Länge der jeweiligen Steckbaugruppe anpaßbaren Tragschiene (TS),
b) zwei Endstücken (K), welche jeweils einen Kupplungsbereich (KP) zur Verbindung mit jeweils einem Ende (ES) der Tragschiene (TS) und auf der Oberseite jeweils eine Führungsnut (FN;FN1,FN2,FN3) zur Aufnahme der Kante einer Steckbaugruppe aufweisen, und mit
c) Nutsegmentteilen (FSn), welche auf der Oberseite jeweils ein Führungsnutsegment (FNn) zur Aufnahme der Kante einer Steckbaugruppe und auf der Unterseite Rastelemente (KLT1,KLT2,RKT1,RKT2,HNT1,HNT2) aufweisen, worüber diese kopfartig so mit der Tragschiene (TS) verrast- bzw. aufsteckbar sind, daß die Führungsnuten der Endstücke (K) und der dazwischen aufgesetzten Nutsegmentteile (FSn) bündig sind.

2. Vorrichtung nach Anspruch 1, wobei die Nutsegmentteile (FSn) jeweils enthalten
a) einen kopfartigen Tragkörper (TK) mit dem dazugehörigen Nutsegmentteil (FSn), und
b) Rastelemente zur Fixierung auf der Tragschiene (TS) in Form von zwei von der Unterseite des Tragkörpers (TK) abweisenden mit vorspringenden, bevorzugt nach innen zugewandten Rastkanten (RKT1,RKT2), welche die Tragschiene (TS) umgreifen oder in entsprechende Nutbereiche (HNT1,HNT2) der Tragschiene (TS) eingreifen.

3. Vorrichtung nach Anspruch 1, wobei die Tragschiene (TS) Rastelemente (KLS1,KLS2,RKS1,RKS2,HNS1,HNS2) aufweist, welche zu den Rastelementen der Nutsegmentteile (FNn) annähernd invers geformt sind.

4. Vorrichtung nach Anspruch 2 und 3, wobei
a) die Rastelemente der Tragschiene (TS) in Form von zwei von der Oberseite der Tragschiene (TS) abweisenden Kantleisten (KLS1,KLS2) mit vorspringenden, bevorzugt nach außen abgewandten Rastkanten (RKS1,RKS2) ausgeführt sind,
b) die Kantleisten (KLT1,KLT2) der Nutsegmentteile (FSn) in die von den Kantleisten (KLS1,KLS2) der Tragschiene (TS) gebildeten Nutbereiche (HNS1,HNS2), und
c) die Kantleisten (KLS1,KLS2) der Tragschiene (TS) in die von den Kantleisten (KLT1,KLT2) der Nutsegmentteile (FSn) gebildeten Nutbereiche (HNT1,HNT2) eingreifen.

5. Vorrichtung nach einem der vorangegangenen Ansprüche, wobei die Führungsschiene (TS) ein näherungsweise u- oder v-förmiges Querschnittsprofil aufweist.

6. Vorrichtung nach einem der vorangegangenen Ansprüche, wobei die Unterseite (US) der Führungsschiene (TS) eine näherungsweise bootsförmige Außenkontur aufweist (Fig.5).

7. Vorrichtung nach einem der vorangegangenen Ansprüche, wobei ein Bereich einer der das Führungsnutsegment (FNn) eines Nutsegmentteiles (FSn) bildenden Seitenwände (SW2) vom Nutgrund getrennt und blattfederartig glockenkurvenförmig, eine elastische Verengung der Breite des Führungsnutsegments (FNn) bildend geformt ist.

8. Vorrichtung nach einem der vorangegangenen Ansprüche, wobei ein Kupplungsbereich (KP) der Endstücke (K) eine dem Querschnittsprofil der Tragschiene (TS) entsprechende Einstecköffnung (EO) für einen, einen Einsteckbereich (ES) bildenden Teil der Tragschiene (TS) aufweist.

9. Vorrichtung nach Anspruch 8, wobei der oberhalb der Einstecköffnung (EO) befindliche Teil (OT) des Kupplungsbereiches (KP) eines Endstücks (K) eine mit einem Nutsegmentteil (FSn) annähernd übereinstimmende Querschnittsform aufweist.

10. Vorrichtung nach einem der vorangegangenen Ansprüche, wobei die den kopfartig aufgesteckten Nutsegmentteilen (FSn) abgewandten Unterseite (US) der Tragschiene (TS) zwei dachförmige Schägflächen (AB) aufweist.

## Claims

1. Guide rail for retaining plug-in assemblies in a mounting rack, having
a) a supporting rail (TS) which can be matched to the length of the respective plug-in assembly,
b) two end pieces (K) which each have a coupling region (KP) for connection in each case to one end (ES) of the supporting rail (TS), and each have, on the top side, a guide groove (FN; FN1, FN2, FN3) for accommodating the edge of a plug-in assembly, and having
c) groove segment parts (FSn) which each have, on the top side, a guide groove segment (FNn) for accommodating the edge of a plug-in assembly and, on the underside, latching elements (KLT1, KLT2, RKT1, RKT2, HNT1, HNT2), by means of which the said groove segment parts can be latched to, or plugged onto, the supporting rail (TS) in the manner of a head in such a way that the guide grooves of the end pieces (K) and of the groove segment parts (FSn) fitted on in between are flush.

2. Device according to Claim 1, the groove segment parts (FSn) each containing
a) a head-like supporting body (TK) with the associated groove segment part (FSn), and
b) latching elements for fixing on the supporting rail (TS), in the form of two edge strips (KLT1, KLT2) which protrude at the underside of the supporting body (TK) and have projecting latching edges (RKT1, RKT2) which preferably face inwards and engage around the supporting rail (TS) or engage into corresponding groove regions (HNT1, HNT2) of the supporting rail (TS).

3. Device according to Claim 1, the supporting rail (TS) having latching elements (KLS1, KLS2, RKS1, RKS2, HNS1, HNS2) which have an approximately inverse shape with respect to the latching elements of the groove segment parts (FNn).

4. Device according to Claims 2 and 3,
a) the latching elements of the supporting rail (TS) being designed in the form of two edge strips (KLS1, KLS2) which protrude at the top of the supporting rail (TS) and have projecting latching edges (RKS1, RKS2) which preferably face outwards,
b) the edge strips (KLT1, KLT2) of the groove segment parts (FSn) engaging into the groove regions (HNS1, HNS2) formed by the edge strips (KLS1, KLS2) of the supporting rail (TS), and
c) the edge strips (KLS1, KLS2) of the supporting rail (TS) engaging into the groove regions (HNT1, HNT2) formed by the edge strips (KLT1, KLT2) of the groove segment parts (FSn).

5. Device according to one of the preceding claims, the guide rail (TS) having an approximately u- or v-shaped cross-sectional profile.

6. Device according to one of the preceding claims, the underside (US) of the supporting rail (TS) having an approximately boat-shaped outer contour (Figure 5).

7. Device according to one of the preceding claims, a region of one (SW2) of the side walls which form the guide groove segment (FNn) of a groove segment part (FSn) being separated from the base of the groove and shaped like a leaf spring curved in a bell shape, forming an elastic constriction of the width of the guide groove segment (FNn).

8. Device according to one of the preceding claims, a coupling region (KP) of the end pieces (K) having an insertion opening (EO) which corresponds to the cross-sectional profile of the supporting rail (TS) and is intended for a part, which forms an insertion region (ES), of the supporting rail (TS).

9. Device according to Claim 8, that part (OT) of the coupling region (KP) of an end piece (K) which is situated above the insertion opening (EO) having a cross-sectional shape which approximately corresponds to a groove segment part (FSn).

10. Device according to one of the preceding claims, the underside (US), which faces away from the groove segment parts (FSn) plugged on in the manner of a head, of the supporting rail (TS) having two roof-shaped bevelled faces (AB).

## Revendications

1. Rail de guidage pour la fixation de modules d'enfichage dans un porte-module, comportant
a) un rail (TS) de support, dont la longueur peut être adaptée au module d'enfichage associé.
b) deux embouts (K), qui comportent chacune une région (KP) de couplage pour la liaison à chacune des extrémités (ES) du rail (TS) de support et, sur la face supérieure, chacune une rainure (FN ; FN1 ; FN2 ; FN3) de guidage pour la réception de l'arête d'un module d'enfichage, et comportant
c) des parties (FSn) de segment de rainure qui comportent sur la face supérieure chacune un segment (FNn) de rainure de guidage pour la réception de l'arête d'un module d'enfichage et sur la face inférieure, des éléments (KLT1, KLT2, RKT1, RKT2, HNT1, HNT2) d'encliquetage, par l'intermédiaire desquels des parties peuvent être encliquetées et passées à la façon d'un rail supérieur sur le rail (TS) de support de telle manière que les rainures de guidage de l'embout (K) et des parties (FSn) de segment de rainure posées entre elles sont en affleurement.

2. Dispositif suivant la revendication 1, les parties (FSn) de segment de rainure comportant chacune
a) un élément (TK) de support en forme de tête comportant la partie (FSn) de segment de rainure associée et
b) des éléments d'encliquetage pour l'immobilisation sur le rail (TS) de support en forme de deux baguettes (KLT1, KLT2) à arêtes vives s'écartant de la face inférieure de l'élément (TK) de support et comportant des arêtes (RKT1, RKT2) d'encliquetage en saillie, de préférence tournées vers l'intérieur, qui entourent le rail (TS) de support ou qui rentrent dans des régions (HNT1, HNT2) de rainure correspondantes du rail (TS de support).

3. Dispositif suivant la revendication 1, le rail (TS) de support comportant des éléments (KLS1, KLS2, RKS1, RKS2, HNS1, HNS2) d'encliquetage qui sont formés de manière à peu près opposée aux éléments d'encliquetage des parties (FNn) de segment de rainure.

4. Dispositif suivant les revendications 2 et 3,
a) les éléments d'encliquetage du rail (TS) de support étant réalisés en forme de deux baguettes (KLS1, KLS2) à arêtes vives s'écartant de la face supérieure du rail (TS) de support et comportant des arêtes (RKS1, RKS2) d'encliquetage en saillie. de préférence éloignées vers l'extérieur.
b) les baguettes (KLT1, KLT2) à arêtes vives des parties (FSn) de segment de rainure rentrant dans les régions (HNS1, HNS2) de rainure formées par les baguettes (KLS1, KLS2) à arêtes vives du rail (TS) de support, et
c) les baguettes (KLS1, KLS2) à arêtes vives du rail (TS) de support rentrant dans les régions (HNT1, HNT2) de rainure formées par les baguettes (KLT1, KLT2) à arêtes vives des parties (FSn) de segment de rainure.

5. Dispositif suivant l'une des revendications précédentes, le rail (TS) de guidage ayant un profil de section transversale à peu près en forme de U ou en forme de V.

6. Dispositif suivant l'une des revendications précédentes, la face (US) inférieure du rail (TS) de guidage ayant un contour extérieur à peu près en forme de bateau (figure 5).

7. Dispositif suivant l'une des revendications précédentes, une région de l'une (SW2) des parois latérales formant le segment (FNn) de rainure de guidage d'une partie (FSn) de segment de rainure étant réalisée de manière séparée du fond de la rainure et, à la façon d'un ressort à lame, en forme de courbe en cloche, en formant un rétrécissement élastique de la largeur du segment (FNn) de rainure de guidage.

8. Dispositif suivant l'une des revendications précédentes, une région (KP) de couplage de l'embout (K) comportant une ouverture (EO) d'enfichage correspondant au profil de section transversale du rail (TS) de support, prévue pou une partie du rail (TS) de support formant une région (ES) d'enfichage.

9. Dispositif suivant la revendication 8, la partie (OT) de la région (KP) de couplage d'un embout (K) se trouvant au-dessus de l'ouverture (EO) d'enfichage et ayant une forme de section transversale coïncidant à peu près avec une partie (FSn) de segment de rainure.

10. Dispositif suivant l'une des revendications précédentes, la face (US) inférieure du rail (TS) de support éloigné des parties (FSn) de segment de rainure enfilées à la façon d'un rail supérieur comportant deux faces (AB) en biais en forme de toit.
